# EUROPEAN PATENT APPLICATION

(11) **EP 4 601 422 A1**
(43) Date of publication of application: **13.08.2025**
(21) Application number: 24156613.2
(22) Date of filing: 08.02.2024
(51) Int. Cl.: H05K 3/30, H05K 3/22, H05K 13/04, H05K 3/32

(54) **ELECTRONIC ASSEMBLY, METHOD FOR MANUFACTURING THE ELECTRONIC ASSEMBLY AND METHOD FOR DISASSEMBLING THE ELECTRONIC ASSEMBLY**

(71) Applicant: Robert Bosch GmbH, 70442 Stuttgart (DE)
(72) Inventor: Molnar, Gergely, Budapest (HU)

(57) **Abstract**

The invention concerns an electronic assembly 1 comprising a printed circuit board 2; a plurality of electronic components 4; a component holder 7 for holding the plurality of the electronic components 4, whereby the component holder 7 is mechanically fixed to the printed circuit board 2 and whereby the electronic components 4 are electrically connected to the printed circuit board 2 by an electrically conductive adhesive 9.

## Description

Object of the invention is an electronic assembly comprising the features of the preamble of claim 1. A further object of the invention is a method for manufacturing the electronic assembly and for disassembling the electronic assembly.

### Prior art

An electronic assembly often comprises a printed circuit board, whereby in many cases electronic components are soldered to the printed circuit board. The document EP 2 849 548 B1 discloses a method for creating a soldered connection, whereby at least a first layer and a second layer are deposited onto a support element, wherein the first layer has at least metal particles and additives, in particular flux, wherein the second layer has at least solder, wherein the support element and the at least two layers then undergo heat treatment in which the second layer is melted and penetrates into the structure of the first layer, wherein the first layer and the second layer are deposited onto the support element without covering one another.

### Disclosure of the invention

Object of the invention is an electronic assembly comprising the features of claim 1, a method for manufacturing the electronic assembly comprising the features of claim 9 and a method for disassembling the electronic assembly with the features of claim 10.

Preferred and/or advantageous embodiments of the invention are disclosed by the dependent claims, the description as follows and the figure.

Subject-matter of the invention is an electronic assembly, which can be used in all kinds of devices or apparatuses. For example, the electronic assembly can be used in sensor devices, computer devices, television devices, automotive devices, avionic devices et cetera.

The electronic assembly comprises the printed circuit board, also called PCB. The printed circuit board takes the form of a laminated sandwich structure of conductive and insulating layers, whereby each of the conductive layers is designed with a pattern of traces, planes and other features (similar to wires on a flat surface) etched from one or more sheet layers of copper laminated onto and/or between sheet layers of a non-conductive substrate.

The electronic assembly furthermore comprises a plurality of electronic components. The electronic assembly may comprise more than 20, preferably more than 50 electronic components. The electronic components may be selected from a group comprising resistors, coils, capacitors, chips, ICs, batteries etc.

Furthermore, a component holder is provided, which is adapted for holding the plurality of the electronic components. Especially, the component holder is adapted for loss-proof holding the electronic components.

According to the invention it is proposed, that the component holder is mechanically fixed to the printed circuit board. Preferably, the component holder is mechanically fixed by detachable connection, so that the component holder can be detached from the printed circuit board. Alternatively, the connection is a one-way connection, which can only be detached in a destructive manner. Preferably, the connection can be detached or disintegrated heat-free and/or mechanically.

The electronic components are electrically connected to the printed circuit board by an electrically conductive adhesive. The electrically conductive adhesive is especially realized as cold-working adhesive, whereby the adhesive process is performed by temperatures lower than 150°C. Especially, the electrically conductive adhesive can be detached and/or dissolved by temperatures lower than 150°C.

It is a finding of the invention, that during the lifetime cycle of the electronic assembly not only the manufacturing of the electronic assembly but also the disassembling and the recycling of the parts of the electronic assembly is important. In case the electronic components are soldered to the printed circuit board, they can only be detached by temperatures, which also destroy the electronic components themselves as well as the printed circuit board. In case instead of solder the electrically conductive adhesive is used, it is possible to disassemble the electronic assembly in a temperature range, which is below the destruction temperature of the printed circuit board and/or the electronic components. In this case the parts of the electronic assembly can be recycled separately. For adapting the manufacturing process, the component holder is used for placing the electronic components in a parallel feed movement until the printed circuit board, so that all electronic components can be glued and electrically contacted to the printed circuit board in one manufacturing step.

In a preferred embodiment the electronic components are positively and/or form-fit secured in the component holder. Especially, the electronic components are not material-locked in the component holder. On the one hand side, the electronic components can easily be arranged in the component holder. Due to the securement in the component holder, the plurality of the electronic components can be arranged in a process-safe manner on the printed circuit board. Last but not least, the electronic components can be disassembled from the component holder and can be recycled.

For an easy implementation it is preferred, that the components are snap-fit in the component holder. This allows an easy and failure-free mounting of the electronic components in the component holder.

It is especially preferred that the component holder is realized as a mounting aid for parallel holding the plurality of the electronic components during manufacturing and/or assembling the electronic assembly.

The electrically conductive adhesive is a conductive glue for attaching and connecting the electronic components to the printed circuit board. The adhesive component in the electrically conductive adhesive can be a varnish, synthetic resin, or silicone. The conductive component of the electrically conductive adhesive can be silver, nickel, copper or graphite. The processing temperature of the electrically conductive adhesive is preferably below 200°C especially below 100°C and preferred equal to a room temperature. On the one hand side the electrically conductive adhesive can easily be used for assembling the electronic assembly, thereby providing a good electronic connection between the electronic components and the printed circuit board. On the other hand side, the electrically conductive adhesive can be dissolved, softened or disintegrated also by temperatures below to an 200°C, so that the disassembling and recycling of the electronic assembly is possible.

In a preferred embodiment the component holder is made of an insulating material. For example, the insulating material is a synthetic material, especially plastic. With the insulating material it is prevented that the electronic components contact with each other and/or with the printed circuit board in an unwanted or unintended manner. Thus, short-circuits are prevented.

Preferably, the component holder is positively and/or form-fit-secured to the printed circuit board. Especially, the component holder is not material-locked to the printed circuit board. For example, the component holder is snap-fit connected with the printed circuit board. On the one hand side the assembling of the electronic assembly is improved, because the component holder needs only to be connected to the printed circuit board. On the other hand side, it is possible to separate the component holder from the printed circuit board for disassembling and/or recycling the electronic assembly.

It is especially preferred that the connection between the electronic components and the printed circuit board is solder-free and/or unsoldered. Especially the connection is not realized as a material-lock, thermal-based metal-connection.

A further subject-matter of the invention is a method for manufacturing the electronic assembly as described above.

In preparing step, the plurality of electronic components is arranged in the component holder. The component holder with electronic components represents a self-retaining intermediate product on the way to the electronic assembly.

In a further preparing step the electrically conductive adhesive is placed on component contacts of the electronic components and/or on circuit contacts for the electronic components on the printed circuit board. During placing the electrically conductive adhesive on the component contacts of the electronic components, the electronic components are held by the component holder. This allows a high degree of automation of the manufacturing method.

During a combining step, the component holder is mechanically fixed to the printed circuit board, whereby with mechanical fixing the component contacts and the circuits contacts are electrically and mechanically connected by the electrically conductive adhesive. The combining step is simplified in case the mechanical fixing is realized by establishing the snap-fit connection between the component holder and the printed circuit board. During the combining step, the electronic components are pressed against the printed circuit board by the component holder.

The component holder may be left within the electronic assembly, alternatively it can be removed, in case it is not further needed.

A further subject matter of the invention is a method for disassembling the electronic assembly as described above or as manufactured by the method as described above.

The disassembling method comprises the heating step whereby the electronic assembly is heated for disintegrating the electrically conductive adhesive, so that the mechanical connection between the electronic components and the printed circuit board is opened or disconnected. In a removing step, the component holder with a plurality of the electronic components is removed from the printed circuit board. The disassembling method allows a separation of the electronic components from the printed circuit board, so that the parts of the electronic assembly can be separated and/or recycled.

The invention can be explained in other words as follows: Currently the PCB has soldered and glued components with SMD, SMD, BGA etc. Current PCB design are difficult to disassemble and soldered components cannot withstand in high temperature. The new method is used without soldering, liquid metal ensures the surface contacts. The PCB is designed in the usual manner, but the components (chips, resistors etc.) are not soldered to it. With 3D printer need to print one or two (for double sided PCB) recyclable plastic sheet (or other material with thermal conductivity but it should not be electrically conductive/capacitive) that contain precisely shaped holes/places for PCB components. The components of the PCB get stuck in the sheet and that sheet is attached to the PCB. Before the sheet with components and the PCB are snapped in/attached to each other, the liquid metal applied on the pins of the components to ensure the appropriate contacts. PCB work with separated components and holder sheet.

Further features, advantages and effects of the invention will become apparent by the description of a preferred embodiment and by the figure as attached. The figure show:

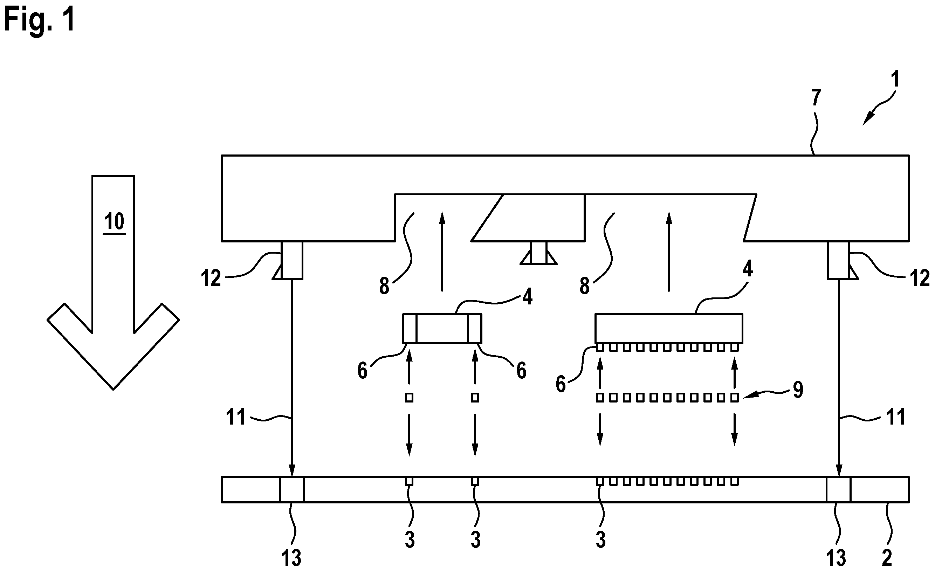

Fig. 1 a schematic view of an electronic assembly during assembling as an embodiment of the invention.

Figure 1 shows a schematic view of an electronic assembly 1 as an embodiment of the invention. The electronic assembly is shown during a method for manufacturing the electronic assembly 1.

The electronic assembly 1 comprises a printed circuit board 2, which can have insulating and conductive layers. The printed circuit board 2 also comprises board circuits contacts 3 as electronic interfaces.

Figure 1 shows a plurality of electronic components 4 as further parts of the electronic assembly 1. As examples, a resistor and a chip are shown. The electronic components 4 each comprising component contacts 6 as electronic interfaces of the electronic components 4.

Furthermore, component holder 7 is shown, which can be realized as a sheet of plastic or the like. The component holder 7 has the function of holding the electronic components 4. For this purpose, the component holder 7 comprises receptacles 8 for the electronic components 4. Each receptacle 8 is adapted to the matching electronic component 4. The electronic components 4 are held by the receptacles 8 positively and/or form-fit-secured. In the embodiment as shown in figure 1, the electronic components 4 can be snap-fit in the receptacles 8 of the component 7. The component holder 7 is a self-retaining intermediate product on the way to the final electronic assembly 1. In a preparing step, the electronic components 4 are attached to the component holder 7. After attaching and thus securing the electronic components 4 to the component holder 7, the circuit contacts 3 and/or the component contacts 6 are covered by an electrically conductive adhesive 9 in a further preparing step. The electrically conductive adhesive 9 is selectively placed on the contacts 3 and/or 6. The electrically conductive adhesive 9 can have a matrix, which is realized as a glue, whereby conductive elements, like metal power or graphic power, are integrated in the matrix.

In a combining step the component holder 7 is mechanically fixed to the printed circuit board 2 as it is indicated by the large arrow 10. During the combining, the electronic components 4 are pressed against the mechanical printed circuit board 2, so that a mechanical and electronic connection between the contacts 3, 6 by the electrically conductive adhesive 9 is reached. After that the contacts 3, 6 the contacts 3, 6 are mechanically fixed, especially glued, to each other and electrically connected, by the electrically conductive adhesive 9.

For finally fixing the component holder 7 to the printed circuit board 2 a snap-fit connection 11 is provided, whereby the component holder 7 provides hooks 12 and the printed circuit boards to provides holes 13 for receiving the hooks 11 and for establishing the snap-fit connection 11. After the hardening of the electrically conductive adhesive 9 the electronic assembly 1 is finalized.

It shall be underlined, that the connection established by the electrically conductive adhesive 9 is a low-temperature or cold connection, so that no additional heating like it is used for soldering, is needed.

One idea of the electronic assembly 1 is to provide a possibility for disassembling and especially recycling the electronic assembly 1. During the method for disassembling a heating step is performed, whereby the electronic assembly 1 is heated for disintegrating or breaking up the electrically conductive adhesive 9 so that the connection between the contacts 3 and 6 is separated.

In a removing step the component holder 7 with the plurality of electronic components 4 can be separated from the printed circuit board 2, so that the single components of the electronic assembly 1 can be separated and recycled.

## Claims

1. Electronic assembly (1) comprising
a printed circuit board (2);
a plurality of electronic components (4);
a component holder (7) for holding the plurality of the electronic components (4),
**characterized in**
**that** the component holder (7) is mechanically fixed to the printed circuit board (2) and that the electronic components (4) are electrically connected to the printed circuit board (2) by an electrically conductive adhesive (9).

2. Electronic assembly (1) according to claim 1, **characterized in that** the electronic components (4) are positively and/or form-fit-secured in the component holder (7).

3. Electronic assembly (1) according to claim 2, **characterized in that** the electronic components (4) are snap-fit in the component holder (7).

4. Electronic assembly (1) according to one of the preceding claims, **characterized in that** the component holder (7) is realized as a mounting aid for parallel holding the plurality of the electronic components (4).

5. Electronic assembly (1) according to one of the preceding claims, **characterized in that** the electrically conductive adhesive (9) is a conductive glue for attaching and connecting the electronic components (4) to the printed circuit board (2).

6. Electronic assembly (1) according to one of the preceding claims, **characterized in that** the component holder (7) is made of an electric insulating material.

7. Electronic assembly (1) according to one of the preceding claims, **characterized in that** the component holder (7) is positively and/or form-fit-secured to the printed circuit board (2).

8. Electronic assembly (1) according to one of the preceding claims, **characterized in that** the connection between the electronic components (4) and the printed circuit board (2) is solder-free and/or unsoldered.

9. Method for manufacturing an electronic assembly (1), especially the electronic assembly (1) according to one of the preceding claims, comprising the steps:
arranging a plurality of electronic components (2) in a component holder (7);
arranging an electrically conductive adhesive (9) on component contacts (6) of the electronic components (4) and/or on circuit contacts (3) for the electronic components (4) on a printed circuit board (2);
fixing the component holder (2) to the printed circuit board (2), so that the component contacts (6) and the matching circuit contacts (3) are electrically contacted by the electrically conductive adhesive (9).

10. Method for disassembling the electronic assembly (1) according to one of the claims 1 to 9 and or manufactured by the method of claim 9, comprising the steps:
heating the electronic assembly (1) for disintegrating the electrically conductive adhesive (9);
removing the component holder (7) with the plurality of the electronic components (4) from the printed circuit board (2).
